# EUROPÄISCHE PATENTSCHRIFT

(11) **EP 1 194 958 B1**
(45) Veröffentlichungstag und Bekanntmachung des Hinweises auf die Patenterteilung: **30.11.2005**
(21) Anmeldenummer: 00951207.0
(22) Anmeldetag: 06.06.2000
(51) Int. Cl.: H01L 41/083, H01L 41/053

(54) **PIEZOAKTOR MIT TEMPERATURKOMPENSATION**
PIEZO-ACTUATOR COMPRISING A TEMPERATURE COMPENSATOR
ACTEUR PIEZO-ELECTRIQUE A COMPENSATEUR DE TEMPERATURE

(30) Priorität: 19.06.1999 DE 19928183
(43) Veröffentlichungstag der Anmeldung: 10.04.2002
(73) Patentinhaber: ROBERT BOSCH GMBH, 70442 Stuttgart (DE)
(72) Erfinder: BOECKING, Friedrich, D-70499 Stuttgart (DE)
(86) Internationale Anmeldenummer: PCT/DE2000/001838
(87) Internationale Veröffentlichungsnummer: WO 2000/079614

(56) Entgegenhaltungen:
- DE-A- 3 037 078
- DE-A- 19 650 900
- DE-A- 19 849 203
- US-A- 4 550 744

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Bei der Positionierung von Ventilen werden die zuvor genannten Piezoaktoren häufig eingesetzt. Dabei ist hier unter anderem zu beachten, dass ihr Hubvermögen zur Betätigung, beispielsweise eines Ventilstössels, relativ klein ist. Andererseits führt die unterschiedliche Wärmedehnung der Keramik des Piezoelements und des Gehäuses dadurch zu Problemen; das Piezoelement hat eine sehr geringe Temperaturdehnung und das, in der Regel metallische Gehäuse hat eine positive Temperaturdehnung, was zu einer Drift der Position des Ventilstössels ohne eine Ansteuerung des Piezoelements führen kann.

In üblicher Weise konnte man solche Störeffekte bisher nur durch die Anwendung sehr teurer Materialien, wie z.B. Invar, vermindern, die eine negative Temperaturdehnung aufweisen. Ein anderer Weg bestand darin, zum Piezoelement in Reihe ein Material mit hoher Temperaturdehnung zu schalten, womit sich jedoch die Steifigkeit des Systems und damit die Aktorkraft reduziert.

Aus der DE 198 49 203 A1 ist ein Piezoaktor bekannt, der ein keramisches Piezoelement mit einem im wesentlichen parallel zum Piezoelement liegenden, ebenfalls keramischen Ausgleichselement aufweist. Die Vorspannung des Piezoelements wird von einer Reihe von Druckfedern aufgebracht, die gleichzeitig dem Schließkörper des Ventils als Rückstelleinrichtung dienen.

Aus der DE 196 60 900 A1 ist ein auf Zug vorgespanntes Vorspannelement bekannt. Dieses ist parallel zum Piezoelement angeordnet, was einen verhältnismäßig großen Bauraum bedingt. Das Piezoelement ist hierbei zwischen einer Festlagerplatte und einer Druckplatte angeordnet.

### Vorteile der Erfindung

Der eingangs beschriebene Piezoaktor, der beispielsweise zur Betätigung eines mechanischen Bauteils verwendbar sein kann, weist ein Piezoelement auf, zu dem ein Ausgleichselement parallel angeordnet ist. Das Piezoelement und das Ausgleichselement weisen im wesentlichen den gleichen Temperaturausdehnungkoeffizienten auf.

In vorteilhafter Weise wird gemäß der Erfindung das Piezoelement auf einfache weise in sich selbst vorgespannt. An einem Ende ist das Piezoelement an einer Festlagerplatte abgestützt, die über eine Feder an einem Gehäuses für den Piezoaktor anliegt. Mit dem anderen Ende ist das Piezoelement über eine Druckplatte mit einer Vorspannfeder verbunden, die wiederum mit ihrem anderen Ende an der Festlagerplatte gehalten ist. Das Ausgleichselement liegt dabei im wesentlichen parallel zu dem Piezoelement und mit einem Ende ebenfalls an der Festlagerplatte an; mit dem anderen Ende stößt das Ausgleichselement fest am Gehäuse an.

Die Vorspannfeder und das Piezoelement sind dabei auf einfache Weise hintereinander angeordnet, wobei das bewegliche Ende des Piezoelements über ein Spannband mit der Druckplatte verbunden ist. Es ist aber auch möglich, dass die Vorspannfeder und das Piezoelement parallel zueinander angeordnet sind, wobei z.B. zwei symmetrisch angeordnete Wellfedern als ebenfalls parallele Vorspannfedern in der Wärmeleitpaste angeordnet werden können.

Es kann auch ein metallisches Gehäuse, beispielsweise aus Stahl, für den Piezoaktor verwendet werden, wobei das Piezoelement im Gehäuse derart verspannbar ist, dass das Ausgleichselement zur Temperaturkompensation immer fest mit dem Piezoelement verbunden ist. Bei einer besonders bevorzugten Ausführungsform der Erfindung liegt zwischen dem Piezoelement und dem Ausgleichselement eine Wärmeleitpaste mit der eine guter Temperaturausgleich zwischen dem Ausgleichselement und dem Piezoelement herstellbar ist.

Der vorgeschlagene Verbund des Piezoelements, des Keramikrings und der Vorspannfeder ist fest mit dem Gehäuse verspannt, wobei die Vorspannkräfte dabei viel höher liegen als die Schaltkräfte des Piezoelements und die Vorsspannfeder eine Temperaturausgleichsbewegung relativ zum Gehäuse erlaubt. Die Größe der Vorspannung kann dabei auf einfache Weise über eine Spannmutter erzeugt werden. Selbst wenn der Temperaturausdehnungskoeffizient des Ausgleichselements nicht dem des Piezoelements entspricht, kann über die Länge des Ausgleichselements der Temperaturausgleich abgestimmt werden. Der gemeinsame Nullpunkt stellt bei der Ausführungsform die Abstützung des Ausgleichselements auf der Spannmutter dar, die fest mit dem Gehäuse verbunden ist.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ausführungsbeispiele des erfindungsgemäßen temperaturkompensierten Piezoaktors, beispielsweise zur Positionierung eines Ventils, werden anhand der Zeichnung erläutert. Es zeigen:
Figur 1 einen Schnitt durch einen mit einem Spannband gehaltenen Piezoaktor mit einem Ausgleichselement und einer dahinter angeordneten Vorspannfeder und
Figur 2 einen Schnitt durch einen Piezoaktor mit einem Ausgleichselement und parallel angeordneten Vorspannfedern.

### Beschreibung der Ausführungsbeispiele

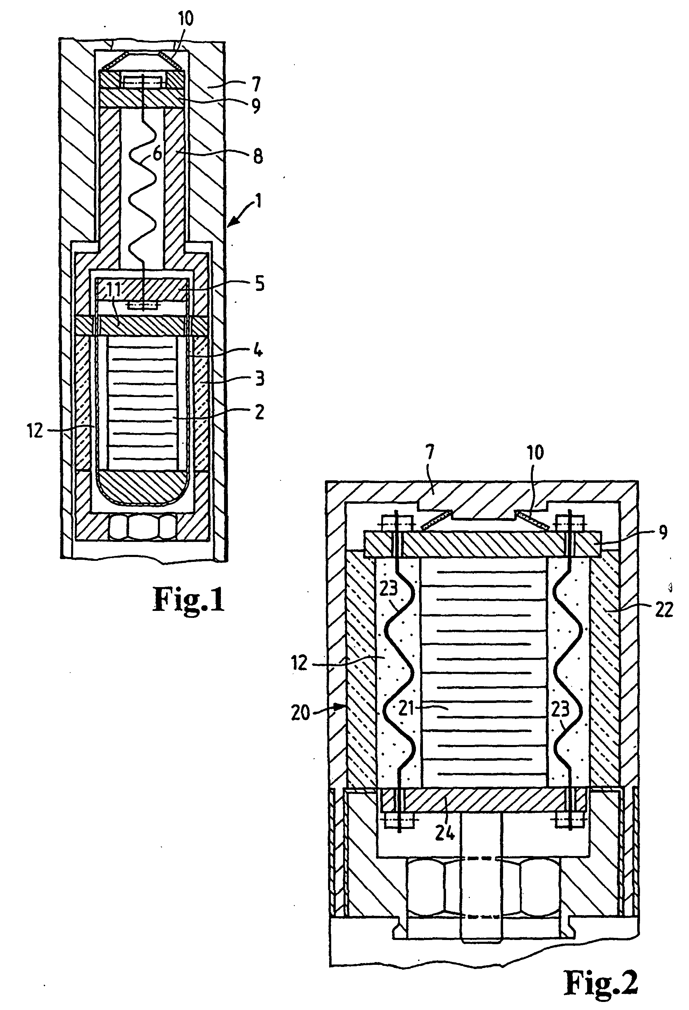

In Figur 1 ist ein Piezoaktor 1 gezeigt, der ein Piezoelement 2 aufweist, das in an sich bekannter Weise aus Piezofolien eines Quarzmaterials mit einer geeigneten Kristallstruktur aufgebaut ist, so dass unter Ausnutzung des sogenannten Piezoeffekts bei Anlage einer äußeren elektrischen Spannung an in dieser Figur nicht gezeigten Elektroden eine mechanische Reaktion des Piezoaktors 1 erfolgt. Bei dem Piezoaktor 1 nach der Figur 1 ist das Piezoelement 2 aus Keramik und ein Ausgleichselement 3 ebenfalls aus Keramik, allerdings ohne Piezoeffekt, aufgebaut.

Das Piezoelement 2 ist von einem Spannband 4 umschlossen, das oben an eine Druckplatte 5 angeschweißt ist, die als Halterung für eine Wellfeder 6 als Vorspannfeder dient. Eine Grundplatte 11, an der das Piezoelement 2 anstößt, liegt zwischen dem Ausgleichselement 3, das andererseits fest am Gehäuse 7, bzw. einer Spannmutter anliegt, und einer Hülsenanordnung 8, die wiederum an einer Festlagerplatte 9 anliegt. Die Festlagerplatte 9 ist wiederum über eine Feder 10 für das Ausgleichselement 3 am Gehäuse 7 gehalten. Die Vorspannfeder 6 ist dabei zwischen der Druckplatte 5 und der Festlagerplatte 9 gehalten. Eine Betätigung des Piezoaktors 1 führt beim Ausführungsbeispiel zu einer axialen Ausdehnung des Piezoelements 2 und damit zu einer axialen Bewegung eines hier nicht sichtbaren Betätigungselements.

Zwischen dem Piezoelement 2 und dem Ausgleichselement 3 ist eine Wärmeleitpaste 12 angebracht, die für einen optimalen Temperaturausgleich dieser beiden Elemente sorgt. Da das Piezoelement 2 und das Ausgleichselement 3 im wesentlichen den gleichen Temperaturausdehnungkoeffizienten aufweisen, führt die temperaturbedingte Dehnungen des Piezoelements 2 und des Ausgleichselements 3 bei der vorgeschlagenen mechanischen Anbringung zu einer Aufhebung der Einflüsse der beiden Elemente 2 und 3 in Wirkrichtung. Somit kann das Betätigungselement in seiner Lage verbleiben.

Ein zweites Ausführungsbeispiel eines Piezoaktors 20 ist in Figur 2 gezeigt, wobei hier die gleich wirkenden Bauelemente mit den gleichen Bezugszeichen wie anhand der Figur 1 versehen sind. Auch bei der Anordnung nach der Figur 2 ist ein Piezoelement 21 und ein Ausgleichselement 22 aus einem Keramikwerkstoff mit annähernd gleichem Temperaturdehnungkoeffizienten hergestellt. Zwischen den Elementen 21 und 22 befinden sich hier parallel angeordnete Wellfedern 23 als Vorspannfedern und eine Wärmeleitpaste 12. Eine Betätigung des Piezoaktors 20 führt auch bei diesem Ausführungsbeispiel zu einer axialen Ausdehnung des Piezoelements 21 und damit zu einer axialen Bewegung eines von einer Druckplatte 24 geführten, hier nicht sichtbaren, Betätigungselements gegen die Vorspannung der Vorspannfedern 23.

Da auch hier das Piezoelement 21 und das Ausgleichselement 22 im wesentlichen den gleichen Temperaturdehnungkoeffizienten aufweisen, führt die temperaturbedingte Dehnungen des Piezoelements 21 und des Ausgleichselements 22 bei der vorgeschlagenen mechanischen Anbringung zu einer Aufhebung der Einflüsse der beiden Elemente 21 und 22 in Wirkrichtung. Somit kann das mit der Druckplatte 24 des Piezoelements 21 fest verbundene Betätigungselement in seiner Lage verbleiben.

## Patentansprüche

1. Piezoaktor mit einem Gehäuse (7) in dem ein keramisches Piezoelement (2), eine Druckplatte (5), eine Festlagerplatte (9), ein im wesentlichen parallel zum Piezoelement (2) liegendes, ebenfalls keramisches Ausgleichselement (3), mit im wesentlichen dem gleichen Temperaturausdehnungskoeffizienten wie das Piezoelement (2), eine zwischen dem Gehäuse (7) und der Festlagerplatte (9) angeordnete Feder (10) zur Vorspannung des Ausgleichselements (3) und wenigstens eine das Piezoelement (2) vorspannende Vorspannfeder (6) vorgesehen sind, wobei die Vorspannfeder (6) und das Piezoelement (2) hintereinander angeordnet sind,
**dadurch gekennzeichnet, daß** das Piezoelement (2) über ein Spannband (4) mit der Druckplatte (5) verbunden ist und an einer Grundplatte (11) anstößt, welche zwischen dem Ausgleichselement (3) und einer an der Festlagerplatte (9) anliegenden Hülsenanordnung (8) angeordnet ist.

2. Piezoaktor nach Anspruch 1, **dadurch gekennzeichnet, daß** zwischen dem Piezoelement (2) und dem Ausgleichselement (3) eine Wärmeleitpaste (12) angeordnet ist.

3. Piezoaktor nach Anspruch 1 oder 2, **dadurch gekennzeichnet, daß** die Vorspannfeder aus mindestens einer Wellfeder (6) gebildet ist.

4. Piezoaktor nach einem der vorhergehenden Ansprüche, **dadurch gekennzeichnet, daß** das Piezoelement (2) aus einem Mehrschichtaufbau von quer angeordneten keramischen Piezolagen besteht, die sich bei Anlage einer äußeren elektrischen Spannung in Wirkrichtung verlängern.

5. Piezoaktor nach einem der Ansprüche 1 bis 4, **dadurch gekennzeichnet, daß** das Piezoelement (2) aus einem Mehrschichtaufbau von quer angeordneten keramischen Piezolagen besteht, die sich bei Anlage einer äußeren elektrischen Spannung in Wirkrichtung verlängern und daß das Ausgleichselement (3) aus längs angeordneten Piezolagen besteht, die sich bei Anlage einer äußeren elektrischen Spannung in wirkrichtung verkürzen.

## Claims

1. Piezo actuator with a housing (7), in which a ceramic piezo element (2), a pressure plate (5), a fixed bearing plate (9), a likewise ceramic compensating element (3), lying substantially parallel to the piezo element (2) and having essentially the same coefficient of thermal expansion as the piezo element (2), a spring (10), arranged between the housing (7) and the fixed bearing plate (9) for biasing the compensating element (3), and at least one biasing spring (6), biasing the piezo element (2), are provided, the biasing spring (6) and the piezo element (2) being arranged one behind the other, **characterized in that** the piezo element (2) is connected to the pressure plate (5) via a tightening strap (4) and butts against a base plate (11), which is arranged between the compensating element (3) and a sleeve arrangement (8) lying against the fixed bearing plate (9).

2. Piezo actuator according to Claim 1, **characterized in that** a heat sink paste (12) is arranged between the piezo element (2) and the compensating element (3).

3. Piezo actuator according to Claim 1 or 2, **characterized in that** the biasing spring is formed by at least one zigzag spring (6).

4. Piezo actuator according to one of the preceding claims, **characterized in that** the piezo element (2) comprises a multilayer structure of transversely arranged ceramic piezo layers, which become longer in the effective direction when an external electric voltage is applied.

5. Piezo actuator according to one of Claims 1 to 4, **characterized in that** the piezo element (2) comprises a multilayer structure of transversely arranged ceramic piezo layers, which become longer in the effective direction when an external electric voltage is applied, and **in that** the compensating element (3) comprises longitudinally arranged piezo layers, which become shorter in the effective direction when an external electric voltage is applied.

## Revendications

1. Actionneur piézoélectrique muni d'un boîtier (7) dans lequel se trouvent un élément piézoélectrique (2) céramique, une plaque de pression (5), une plaque d'appui fixe (9), un élément de compensation (3) également céramique essentiellement parallèle à l'élément piézoélectrique (2) et dont le coefficient de dilatation thermique est pratiquement identique à l'élément piézoélectrique (2), un ressort (10) placé entre le boîtier (7) et la plaque d'appui fixe (9) et destiné à précontraindre l'élément de compensation (3) et au moins un ressort de précontrainte (6) qui précontraint l'élément piézoélectrique (2), le ressort de précontrainte (6) et l'élément piézoélectrique (2) étant placés l'un derrière l'autre,
**caractérisé en ce que**
l'élément piézoélectrique (2) est relié par une bande de serrage (4) à la plaque de pression (5) et s'appuie contre une plaque de fond (11) placée entre l'élément de compensation (3) et un système de manchons (8) qui s'applique à la plaque d'appui fixe (9).

2. Actionneur piézoélectrique selon la revendication 1,
**caractérisé en ce que**
une pâte thermoconductrice (12) est placée entre l'élément piézoélectrique (2) et l'élément de compensation (3).

3. Actionneur piézoélectrique selon la revendication 1 ou 2,
**caractérisé en ce que**
le ressort de précontrainte est formé d'au moins un ressort ondulé (6).

4. Actionneur piézoélectrique selon l'une des revendications précédentes,
**caractérisé en ce que**
l'élément piézoélectrique (2) consiste en plusieurs couches céramiques piézoélectriques disposées transversalement qui s'allongent en direction active lorsqu'on applique une tension électrique extérieure.

5. Actionneur piézoélectrique selon l'une des revendications 1 à 4,
**caractérisé en ce que**
l'élément piézoélectrique (2) consiste en plusieurs couches piézoélectriques céramiques disposées transversalement qui s'allongent en direction active lorsqu'on applique une tension électrique extérieure, et
l'élément de compensation (3) se compose de couches piézoélectriques disposées longitudinalement qui se raccourcissent en direction active lorsqu'on applique une tension électrique extérieure.
